# DEMANDE DE BREVET EUROPEEN

(11) **EP 1 746 640 A1**
(43) Date de publication de la demande: **24.01.2007**
(21) Numéro de dépôt: 06115027.2
(22) Date de dépôt: 06.06.2006
(51) Int. Cl.: H01L 21/3065

(54) **Procédé de pilotage de la pression dans une chambre de procédé**

(30) Priorité: 14.06.2005 FR 0551589
(71) Demandeur: ALCATEL, 75008 Paris (FR)
(72) Inventeur: Launay, Nicolas, 74000, Annecy (FR)
(74) Mandataire: Sciaux, Edmond

(57) **Abrégé**

La présente invention a pour objet un procédé de traitement par plasma d'un substrat semi-conducteur, dans une chambre de procédé reliée à une ligne de vide par l'intermédiaire d'une vanne, comprenant en alternance au moins une étape de gravure et au moins une étape de passivation, caractérisé en ce qu'il comporte les opérations suivantes :
(a) on définit une pression de référence P_{ref} à laquelle on souhaite effectuer le traitement,
(b) on fixe la position de la vanne lors de la première étape de gravure,
(c) on laisse la pression dans la cha nbre de procédé se stabiliser pendant n cycles,
(d) on mesure la pression dans la chambre de procédé durant l'étape de gravure pendant m cycles, avec m au moins égal à 2, et on calcule une valeur moyenne de pression P_{c} à partir des mesures effectuées,
(e) après n + m cycles, on rectifie la position de la vanne dans en vue d'obtenir une pression dans la chambre de procédé qui se rapproche de la valeur de pression de référence P_{ref},
(e) on renouvelle les étapes (c) à (e) jusqu'à ce que la pression moyenne calculée P_{c} soit sensiblement égale à la valeur de pression de référence P_{ref} de telle sorte qu'il ne soit plus nécessaire de rectifier la position de la vanne.

## Description

La présente invention concerne le domaine du micro-usinage de substrats semi-conducteurs pour la réalisation de composants de microsystèmes électromécaniques (MEMS) ou de microsystèmes électro-optomécaniques (MOEMS). Elle se rapporte plus particulièrement au contrôle et à la régulation de la pression gazeuse dans la chambre de procédé au cours des différentes étapes de la fabrication de composants semi-conducteurs par la technique de gravure alternée par plasma, notamment au procédé utilisé.

Dans les procédés industriels de fabrication ou de traitement de produits dans des enceintes alimentées en gaz de traitement à très basses pressions, il est nécessaire de réguler la pression dans l'enceinte. C'est le cas, par exemple, dans les procédés de fabrication ou de traitement des semi-conducteurs et des systèmes mécaniques microélectroniques (MEMS).

Le substrat est placé dans une enceinte à vide contenant des gaz actifs qui sont ionisés par des moyens de génération de plasma Le traitement comprend généralement des étapes successives qui se déroulent dans une chambre de procédés sous atmosphère à faible pression permettant l'établissement et le maintien d'un plasma.

Pour certaines applications, on utilise des procédés mettant en oeuvre des débits alternés de différents gaz. Par exemple dans le cas de la gravure du silicium, il est courant d'utiliser une succession de cycles comprenant chacun deux étapes : une étape de gravure comprenant l'introduction d'un gaz ou d'un mélange gazeux fluoré, tel que le SF₆, et une étape de dépôt d'un film de passivation sur les surfaces comprenant l'introduction d'un gaz CxFy, tel que le C₄F₈ par exemple. Une ou plusieurs étapes supplémentaires comprenant l'introduction d'un gaz neutre ou de nettoyage peuvent y être ajoutées. Chaque étape comporte l'injection simultanée de gaz dans la chambre de procédés, et pour chaque étape on définit un débit gazeux constant. Cependant la nature et le débit du gaz varient d'une étape à l'autre, ce qui provoque une variation de pression dans la chambre de procédé à chaque étape. Cette pression est un paramètre important pour la maîtrise et la répétitivité des performances des étapes du procédé. Ainsi chaque étape est caractérisée par une pression gazeuse dans la chambre de procédé qu'il faut contrôler et réguler au mieux.

Le vide approprié nécessaire aux différentes étapes de procédé est généré et maintenu par une ligne de vide comprenant des pompes à vide raccordées à la chambre de procédés. Il est possible d'ajuster la pression dans la chambre de procédé grâce à une vanne de laminage disposée à l'entrée de la ligne de pompage. Cependant la durée de chaque étape étant variable et relativement courte (quelques milliseconde à quelques secondes), le temps de réponse de la vanne ne permet pas d'asservir la pression de manière précise. On choisit donc habituellement d'imposer à la vanne une position constante pendant tout le traitement ce qui permet de contrôler approximativement la pression.

On observe aussi une variation de pression dans le temps pour un même procédé. On sait que, pour une même position de la vanne, la pression dans la chambre de procédé peuvent varier selon l'état du réacteur, toutes choses étant égales par ailleurs. La dérive de pression observée peut être due à une modification de l'état de propreté du réacteur, par exemple à cause du dépôt de produits de dégradation générés au cours du traitement. Cette variation dépend aussi du type de vanne de laminage. Par conséquent il faut définir pour chaque installation, et selon l'évolution de l'état du réacteur, une position différente de la vanne pour chacune des étapes du traitement effectué.

Le document WO-2004/093165 propose un procédé de contrôle de la pression lors de l'alternance d'étapes de gravure et de passivation. Le procédé consiste à fixer, en début de traitement, la position de la vanne reliant la chambre de procédé à la turbo-pompe indépendamment pour chaque étape. La position de départ de la vanne est déterminée en fonction de données acquises lors d'une ou plusieurs étapes antérieures du même type (contrôle en mode "position"). Après au moins une partie de l'étape dans cette position, la pression est ensuite régulée en faisant varier la position de la vanne au moyen d'un algorithme de contrôle (contrôle en mode "pression").

Comme la pression dans la chambre de procédé est un paramètre important pour la maîtrise et la répétitivité des performances du traitement de gravure par plasma, il est nécessaire de réguler ce paramètre de manière précise. La présente invention a pour but de permettre de minimiser la dérive de la pression au cours du déroulement du traitement, en proposant un procédé de contrôle et de régulation de la pression dans une chambre de procédé.

L'objet de la présente invention est un procédé de traitement par plasma d'un substrat semi-conducteur dans une chambre de procédé reliée à une ligne de vide par l'intermédiaire d'une vanne, ledit traitement comportant une pluralité de cycles comprenant en alternance au moins une étape de gravure durant laquelle on introduit un gaz de gravure et au moins une étape de passivation durant laquelle on introduit un gaz de passivation dans ladite chambre, caractérisé en ce qu'il comporte les opérations suivantes :
(a) on définit une pression de référence P_{ref} à laquelle on souhaite effectuer le traitement,
(b) on fixe la position de la vanne lors de la première étape de gravure,
(c) on laisse la pression dans la chambre de procédé se stabiliser pendant n cycles,
(d) on mesure la pression dans la chambre de procédé durant l'étape de gravure pendant m cycles, avec m au moins égal à 2, et on calcule une valeur moyenne de pression P_{c} à partir des mesures effectuées,
(e) après n + m cycles, on rectifie la position de la vanne dans en vue d'obtenir une pression dans la chambre de procédé qui se rapproche de la valeur de pression de référence P_{ref},
(e) on renouvelle les étapes (c) à (e) jusqu'à ce que la pression moyenne calculée P_{c} soit sensiblement égale à la valeur de pression de référence P_{ref} de telle sorte qu'il ne soit plus nécessaire de rectifier la position de la vanne.

Par sensiblement égale, il faut comprendre que la pression moyenne calculée à partir des pressions mesurées se trouve dans une zone de tolérance autour de la valeur de pression définie comme valeur de référence, comprise entre ±1% et ±5%.

Avantageusement la mesure de pression est effectuée après un temps Δ† de l'ordre du tiers du temps total de l'étape de gravure de manière à disposer d'une pression stable.

Avantageusement encore la mesure de pression est effectuée pendant un temps Δ†ₘ de l'ordre du tiers du temps total de l'étape de gravure de manière à disposer d'une valeur représentative de la pression moyenne dans la chambre de procédé pendant l'étape de gravure.

La position initiale de la vanne est déterminée à partir d'un étalonnage préalablement effectué ou de l'expérience acquise sur le traitement. De manière pratique, la position de la vanne est rectifiée par pas. Par exemple, chaque pas peut représenter 1% de l'ouverture totale de la vanne. Ce qui signifie que dans ce cas la position de la vanne pourra être rectifiée au maximum de 10 pas dans un sens et dans l'autre. Bien entendu tout autre valeur de pas peut être également choisi.

De préférence les mesures sont effectuées sur un nombre de cycles m au moins égale à 3.

Pendant l'étape de dépôt d'un film de passivation, la position de la vanne est la même que celle de l'étape de gravure qui la précède immédiatement. La position de la vanne ne varie pas pendant l'étape de dépôt.

D'autres caractéristiques et avantages de la présente invention apparaîtront à la lecture de la description qui suit d'un mode de réalisation, donné bien entendu à titre illustratif et non limitatif, et dans le dessin annexé sur lequel
- la figure 1 représente schématiquement une installation de fabrication de composants semi-conducteurs,
- la figure 2 représente schématiquement la variation théorique de pression P partielle en fonction du temps t au cours d'un cycle de traitement comportant deux étapes, respectivement d'une part la pression partielle en gaz ou mélange de gaz de gravure (fig.2A) et d'autre part la pression partielle en gaz ou mélange de gaz de passivation (fig.2B),
- la figure 3 montre sous forme schématique le procédé de contrôle et de régulation de la pression selon l'invention,
- la figure 4 montre l'évolution de la pression P totale dans la chambre de procédé en fonction du temps t au cours d'un cycle de traitement comportant deux étapes, dans le cas où on applique le procédé selon l'invention,
- la figure 5 montre l'évolution de la pression P totale dans la chambre de procédé en fonction du temps t de traitement, dans le cas où on applique le procédé selon l'invention.

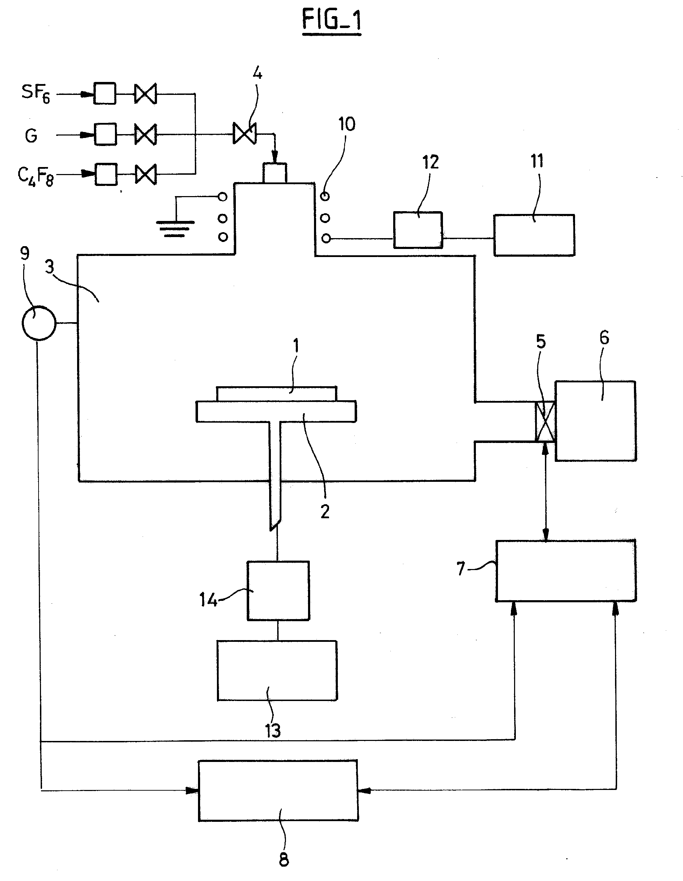

L'installation représentée sur la figure 1 est une installation classiquement utilisée pour la gravure de micro-usinage de substrats en silicium par plasma. Le substrat **1** est placé sur un support **2** qui peut être mobile disposé dans une chambre de procédé **3.**

Durant le traitement, on alterne des étapes de gravure du substrat 1 par un plasma de gaz fluoré, tel que le SF₆, et des étapes de passivation des surfaces grâce à un plasma de gaz CₓF_{y}, tel que le C₄F₈ par exemple. On peut aussi prévoir l'introduction d'un gaz neutre ou de nettoyage G. Les gaz de traitement sont introduit dans la chambre de procédé **3** par un dispositif d'admission comportant une vanne **4.** La pression dans la chambre de procédé **3** est asservie au moyen d'une vanne de laminage **5** disposée à l'entrée de la ligne de vide 6 comprenant des pompes, et associée à un contrôleur **7** piloté par un ordinateur **8.** La pression dans la chambre de procédé **3** est mesurée par un appareil **9** tel qu'un manomètre.

Pendant l'étape de gravure, le gaz actif est excité pour former un plasma au moyen d'un enroulement **10** alimenté par un générateur radiofréquence **11** par l'intermédiaire d'un réseau adaptateur **12.** Les ions produits sont accéléré vers le substrat **1** sous l'effet de la polarisation du substrat **1,** obtenue à l'aide d'un générateur **13** radiofréquence ou basses fréquences associé à un réseau adaptateur **14,** et bombardent les surfaces du substrat **1** qui sont normales à la direction de bombardement. Le substrat **1** est attaqué de manière isotrope par les atomes de fluor et par les espèces neutres issues aussi de l'excitation du gaz de gravure réagissent chimiquement avec la surface du substrat **1.**

Durant l'étape de passivation, le gaz ou mélange gazeux est excité de la même manière par l'ensemble générateur radiofréquence **10, 11, 12** et produit des espèces polymérisables qui se déposent sous forme d'un film de polymère sur toutes les surfaces du substrat **1** exposées au plasma. Les surfaces verticales et les surfaces horizontales sont ainsi recouvertes.

Au cours de l'étape suivante de gravure et sous l'action conjuguée du bombardement ionique vertical obtenu par la polarisation négative du substrat, le film de polymère est pulvérisé et enlevé sur les surfaces horizontales, et la gravure verticale du substrat peut se poursuivre, alors que le polymère restant sur les surfaces verticales s'oppose momentanément à l'action du plasma sur ces surfaces verticales. En répétant ainsi les étapes de gravure avec un plasma de gaz fluoré et les étapes de passivation avec un plasma de gaz CₓF_{y}, on obtient une gravure anisotrope du substrat.

Un cycle peut aussi comporter des étapes supplémentaires, qui sont ni de passivation ni de gravure, utilisant des gaz neutres ou de nettoyage.

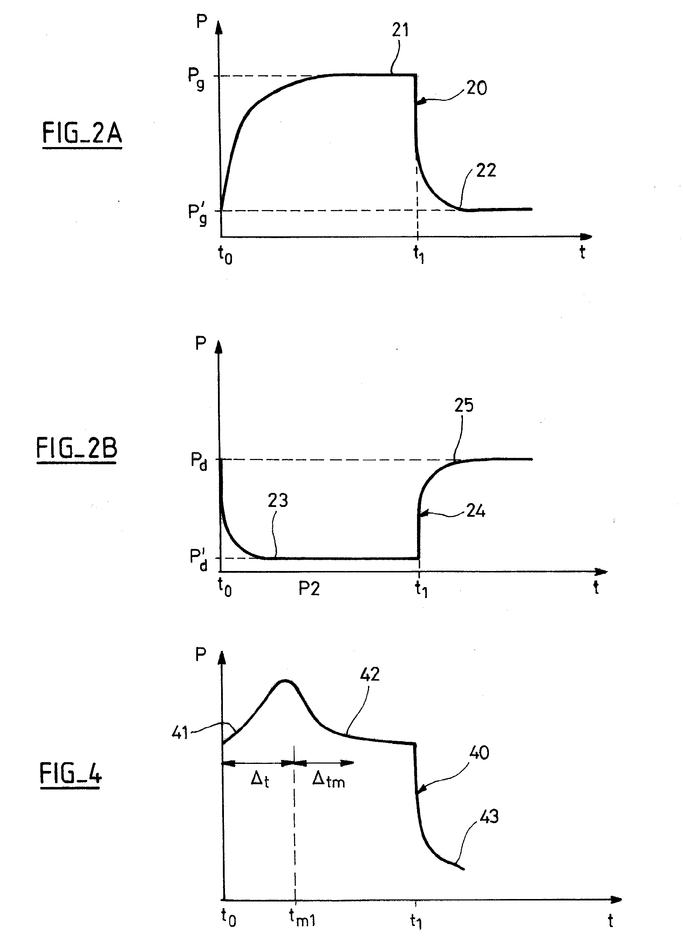

Au cours d'un cycle de traitement comportant deux étapes, les pressions évoluent de manière schématique comme représenté sur la figure 2.

Au début t₀ de l'étape de gravure, un gaz fluoré est introduit dans la chambre de procédé à une pression partielle représentée par la courbe **20.** La portion **21** de la courbe **20** augmente jusqu'à une valeur de pression P_{g}. Le gaz de passivation a une pression partielle P'_{d} qui est représentée par la portion **23** de la courbe **24** (fig.2B).

A la fin t_{f} de l'étape de gravure, l'introduction du gaz de gravure est stoppée, et la partie **22** de sa courbe de pression **20** montre que la pression partielle du gaz de gravure décroît jusqu'à une valeur P'_{g} (fig.2A). Simultanément on procède à l'introduction du gaz de passivation à une pression partielle représentée par la courbe **24.** La portion **25** de la courbe **24** montre que la pression partielle du gaz de passivation augmente jusqu'à une valeur de pression P_{d} (fig.2B).

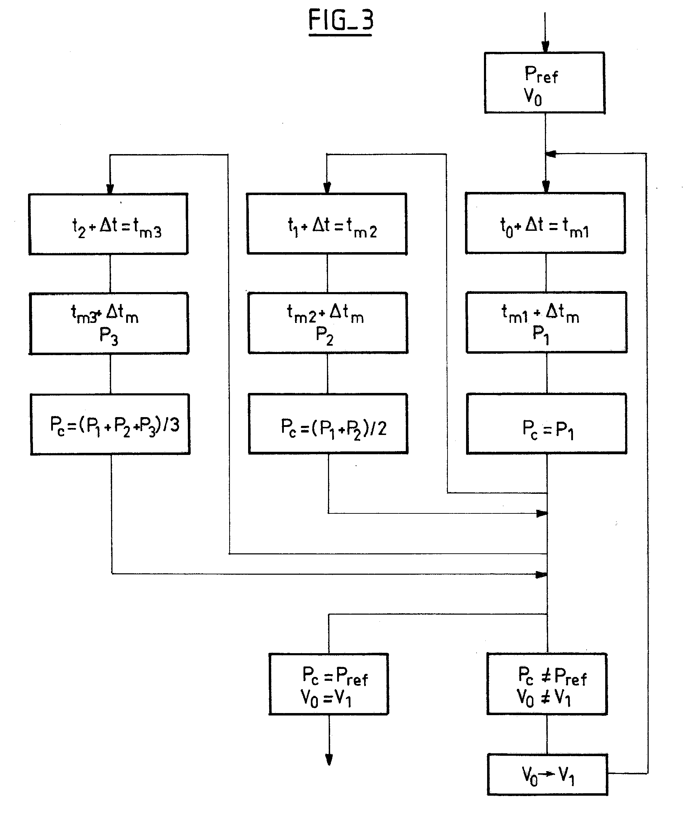

La figure 3 représente schématiquement le procédé selon l'invention. Au début t₀ de l'étape de gravure, le gaz de gravure est introduit dans la chambre de procédé **3** par l'intermédiaire de la vanne **4.** La vanne de laminage **5** est alors placée dans une position V₀ arbitraire afin de régler la vitesse de pompage. La position V₀ de la vanne est maintenue constante pendant quelques cycles afin de permettrent à la pression de se stabiliser. Par ailleurs on définie une pression de référence P_{ref} à laquelle on souhaite travailler.

Après le début t₀ d'une étape de gravure, la position V₀ de la vanne est conservée pendant un intervalle de temps Δt correspondant de préférence à environ un tiers de la durée totale de l'étape de gravure. Après un temps tₘ₁ = t₀ + Δt, on mesure pendant un temps Δtₘ la pression moyenne dans la chambre de procédé qui a une valeur P₁. La valeur P_{c} de la pression moyenne est donc ici égale à la valeur P1 de la pression moyenne mesurée dans l'intervalle de temps considéré.

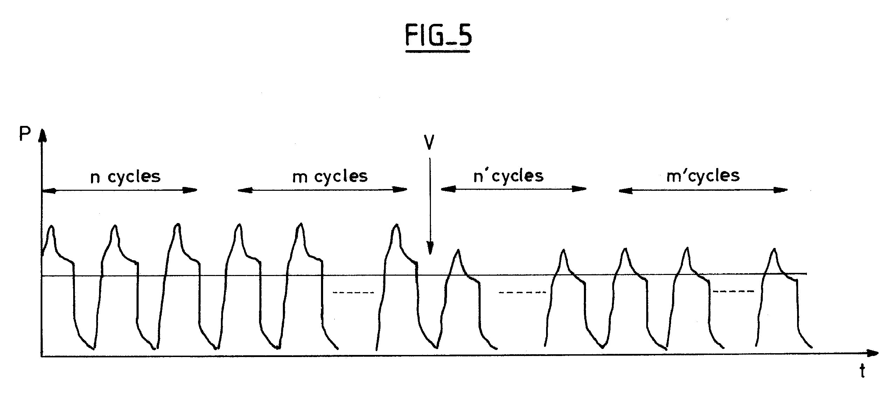

La pression dans la chambre de procédé varie comme représentée par la courbe **40** de la figure 4. Pendant l'introduction du gaz de gravure, la vanne de laminage **5** étant maintenue en position fixée, la pression augmente comme le montre la portion **41** de la courbe **40** correspondant à l'intervalle de temps Δt. La consommation de gaz par la gravure du substrat fait alors décroître puis se stabiliser la pression (portion **42** de la courbe **40**). C'est pendant cette période Δ†ₘ que la pression moyenne est mesurée. La durée de mesure Δ†ₘ peut atteindre un tiers de la durée totale de l'étape. A la fin de l'étape de gravure, l'admission de gaz de gravure est stoppée et la pression décroît pendant un court instant (portion **43** de la courbe **40),** avant que l'admission du gaz de passivation la fasse remonter à nouveau.

Au cours de l'étape de gravure du cycle suivant, la mesure de pression est réitérée après le même intervalle de temps Δt à partir du début t₁ de l'étape de gravure du cycle suivant. Après un temps tₘ₂ = t₁ + Δt, on mesure pendant un temps Δtₘ la pression moyenne dans la chambre de procédé qui a une valeur P₂. On redéfinit alors la valeur calculée P_{c} de la pression moyenne pour qu'elle soit égale à la valeur moyenne (P₁ + P₂)/2 des deux mesures.

Après un temps tₘ₃ = t₂ + Δt à partir du début t₂ de l'étape de gravure du cycle suivant, on peut réitérer la mesure de la pression moyenne dans la chambre de procédé, comme illustré sur la figure 3. On redéfinit à nouveau la valeur de la pression moyenne calculée P_{c} pour qu'elle soit égale à la valeur moyenne (P₁ + P₂ + P₃)/2 des trois mesures.

Les valeurs de P₁, P₂ et P₃ sont habituellement comprises entre 0,5 Pa et 30 Pa. Cette mesure peut être effectuée sur autant de cycle que nécessaire.

Si la pression moyenne calculée Pc est différente de la valeur de la pression de référence P_{ref}, la vanne de laminage **5** est déplacée de la position V₀ à la position V₁ afin de réduire la différence P_{c} ― P_{ref} observée entre la pression moyenne calculée P_{c} dans la chambre de procédé et la valeur de la pression de référence P_{ref}.

Lorque la position de la vanne a été rectifiée, on attend quelques cycles pour laisser la pression se stabiliser avant de refaire une série de mesures analogue à ce qui vient d'être décrit. La valeur de la pression de référence P_{ref} est redéfinie si nécessaire, et la position de la vanne **5** modifiée en conséquence. On tolère un écart compris entre 1% et 5% entre la valeur de référence P_{ref} et la valeur de pression moyenne calculée P_{c} à partir des mesures.

Au bout d'un certain nombre de cycles, la pression est stabilisée. Il n'est plus nécessaire de modifier la position de la vanne de laminage. Lorsque la valeur de la pression moyenne calculée P_{c} est constante et sensiblement égale à la valeur de la pression de référence P_{ref}, la position de la vanne n'est pas modifiée à l'issue des mesures. Si on le souhaite, on peut alors effectuer des contrôles de pression moins fréquents.

Si on observe au cours du temps une dérive de la pression moyenne calculée P_{c} dans la chambre de procédé durant l'étape de gravure, par rapport à la valeur de la pression de référence P_{ref}, les mesures peuvent être refaites et la position de la vanne de laminage **5** réajustée.

La figure 5 montre l'effet du procédé selon l'invention sur l'évolution de la pression P dans la chambre de procédé pendant le temps t de traitement. Pendant n cycles (ici on a représenté ici 3 cycles), la pression est maintenue par la position initiale de la vanne. Au cours des m cycles suivants, des mesures de pression sont effectuées, et une pression moyenne est recalculée après chaque cycle. Après (n + m) cycles, on modifie la position de la vanne (indiqué par V sur le schéma). Dans l'exemple donné, la pression mesurée était trop élevée et la position de la vanne a été modifiée de manière à abaisser légèrement la pression.

On laisse alors la pression se stabiliser pendant n' cycles, puis on effectue à nouveau des mesures sur m' cycles. Si nécessaire, la position de la vanne peut être à nouveau modifiée.

La présente invention n'est pas limitée aux modes de réalisation qui ont été explicitement décrits, mais elle inclut les diverses variantes et généralisations qui sont à la portée de l'homme du métier.

## Revendications

1. Procédé de traitement par plasma d'un substrat semi-conducteur dans une chambre de procédé reliée à une ligne de vide par l'intermédiaire d'une vanne, ledit traitement comportant une pluralité de cycles comprenant en alternance au moins une étape de gravure durant laquelle on introduit un gaz de gravure et au moins une étape de passivation durant laquelle on introduit un gaz de passivation dans ladite chambre, **caractérisé en ce qu'**il comporte les opérations suivantes :
(a) on définit une pression de référence P_{ref} à laquelle on souhaite effectuer le traitement,
(b) on fixe la position de la vanne lors de la première étape de gravure,
(c) on laisse la pression dans la chambre de procédé se stabiliser pendant n cycles,
(d) on mesure la pression dans la chambre de procédé durant l'étape de gravure pendant m cycles, avec m au moins égal à 2, et on calcule une valeur moyenne de pression P_{c} à partir des mesures effectuées,
(e) après n + m cycles, on rectifie la position de la vanne dans en vue d'obtenir une pression dans la chambre de procédé qui se rapproche de la valeur de pression de référence P_{ref},
(e) on renouvelle les étapes (c) à (e) jusqu'à ce que la pression moyenne calculée P_{c} soit sensiblement égale à la valeur de pression de référence P_{ref} de telle sorte qu'il ne soit plus nécessaire de rectifier la position de la vanne.

2. Procédé selon la revendication 1, dans lequel la mesure de la pression est effectuée après un temps Δt de l'ordre du tiers du temps total de l'étape de gravure.

3. Procédé selon l'une des revendications 1 et 2, dans lequel la mesure de la pression est effectuée pendant un temps Δ†ₘ de l'ordre du tiers du temps total de l'étape de gravure.

4. Procédé selon l'une des revendications précédentes, dans lequel m est au moins égal à 3.

5. Procédé selon l'une des revendications précédentes, dans lequel n est au moins égal à 2.

6. Procédé selon l'une des revendications précédentes, dans lequel la position de la vanne est rectifiée d'un pas après chaque série de mesure, chaque pas représentant 1 % de l'ouverture totale de la vanne.

7. Procédé selon la revendication 6, dans lequel la position de la vanne est rectifiée au maximum de 10 pas dans un sens et dans l'autre au cours du traitement.
